(19) **Europäisches Patentamt / European Patent Office / Office européen des brevets**

(11) **EP 2 839 361 B1**

(12) **FASCICULE DE BREVET EUROPEEN**

(45) Date de publication et mention
de la délivrance du brevet:
**23.03.2016 Bulletin 2016/12**

(51) Int Cl.:
**G06F 3/042** $^{(2006.01)}$ **G06F 3/041** $^{(2006.01)}$
**H03K 17/94** $^{(2006.01)}$ **H03K 17/96** $^{(2006.01)}$

(21) Numéro de dépôt: **13719938.6**

(22) Date de dépôt: **28.03.2013**

(86) Numéro de dépôt international:
**PCT/FR2013/050672**

(87) Numéro de publication internationale:
**WO 2013/156702 (24.10.2013 Gazette 2013/43)**

(54) **CAPTEUR TACTILE PHOTOSENSIBLE**

LICHTEMPFINDLICHER TAKTILER SENSOR

PHOTOSENSITIVE TACTILE SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.04.2012 FR 1253649**

(43) Date de publication de la demande:
**25.02.2015 Bulletin 2015/09**

(73) Titulaire: **Commissariat à l'Énergie Atomique
et aux Énergies Alternatives
75015 Paris (FR)**

(72) Inventeurs:
• **ALIANE, Abdelkader
F-38100 Grenoble (FR)**
• **BENWADIH, Mohammed
F-94500 Champagny / Marne (FR)**
• **CARD, Tiphaine
F-38100 Grenoble (FR)**

(74) Mandataire: **Cabinet Laurent & Charras
Le Contemporain
50 Chemin de la Bruyère
69574 Dardilly Cedex (FR)**

(56) Documents cités:
**US-B1- 6 522 032**

**Description**

**DOMAINE DE L'INVENTION**

L'invention a trait au domaine des capteurs tactiles, notamment des capteurs tactiles par détection de pression, et trouve particulièrement application dans les écrans, les claviers, et les pavés tactiles.

**ETAT DE LA TECHNIQUE**

Il est connu des écrans, claviers et pavés tactiles qui détectent une pression exercée sur ceux-ci. Ces dispositifs incluent des capteurs de pression comportant une couche de matériau piézoélectrique réalisée sur un support flexible. En appuyant sur ces dispositifs, la couche de matériau piézoélectrique du ou des capteurs sollicités se déforme et libère des charges électriques qui sont détectées par un circuit électrique dédié. La détection des charges libérées détermine alors qu'une pression est exercée sur le dispositif.

Afin d'obtenir des capteurs de pression de qualité, il est usuellement recherché des matériaux piézoélectriques qui présentent à la fois de bonnes qualités mécaniques et de bonnes qualités piézoélectriques.

Notamment, il est recherché pour ces matériaux une bonne élasticité, une bonne adhérence au support flexible, ainsi qu'une faible différence de coefficients d'expansion thermique avec le support. En effet un matériau piézoélectrique trop rigide est difficilement reportable sur un support flexible, et s'il existe une trop grande différence de coefficients d'expansion thermique, la couche piézoélectrique peut se décoller du support sous l'effet des variations de température. Les capteurs de pression en résultant sont donc mécaniquement fragiles. Il est également recherché des matériaux piézoélectriques ayant une grande constante piézoélectrique, c'est-à-dire libérant une quantité importante de charges lorsqu'ils sont pressés, même légèrement, afin de concevoir des capteurs de haute sensibilité.

Or, les matériaux piézoélectriques actuels présentent soit de bonnes propriétés mécaniques, soit de bonnes propriétés piézoélectriques. Par exemple, parmi les matériaux piézoélectriques couramment utilisés pour les capteurs de pression, on trouve les céramiques dites « PZT » (acronyme du titano-zirconate de plomb) et le « PVDF » (acronyme du polyfluorure de vinylène).

Toutefois, une céramique PZT est pourvue certes d'une constante piézoélectrique élevée, mais présente toutefois un module de Young très élevé, et donc des propriétés mécaniques insuffisantes. Le PVDF présente quand à lui un module de Young faible, et plus généralement de bonnes qualités mécaniques, mais présente cependant une constante piézoélectrique faible.

Pour des questions de robustesse mécanique, les matériaux piézoélectriques présentant une bonne tenue mécanique, et donc un module de Young faible, sont usuellement préférés. Cependant, en raison de la constante piézoélectrique faible, et donc de leur faible réponse à une pression exercée, un montage électrique dit « en capacité » est utilisé pour mesurer la quantité de charges libérées. Dans un tel montage, la couche de matériau piézoélectrique est au contact d'électrodes et forme avec celles-ci un circuit capacitif, dont la capacité varie en fonction des charges électriques libérées. Un capacimètre, connecté aux électrodes, mesure la capacité du circuit capacitif de manière dynamique, notamment en imposant une tension variable entre les électrodes et/ou en injectant dans celles-ci un courant variable de fréquence variable. Un montage électrique en capacité requiert donc des moyens de mesure complexes.

**EXPOSE DE L'INVENTION**

Le but de la présente invention est de proposer un capteur tactile piézorésistif de sensibilité accrue, ne nécessitant pas l'emploi d'un montage électrique en capacité pour mesurer la présence d'un objet à sa surface.

A cet effet, l'invention a pour objet un capteur tactile comportant :

- une couche piézorésistive, dont la résistance électrique varie en fonction de contraintes mécaniques exercées sur celle-ci, la couche piézorésistive étant au moins partiellement transparente à la lumière ;
- une couche photosensible, dont la résistance électrique varie en fonction de la quantité de lumière incidente sur celle-ci, la couche photosensible étant agencée en regard de la couche piézorésistive ; et
- des éléments de connexion électriques connectant électriquement en parallèle la couche piézorésistive et la couche photosensible.

En d'autres termes, le capteur tactile selon l'invention combine deux phénomènes physiques différents et concomitants pour détecter la présence d'un objet sur sa surface. En effet, lorsqu'un objet, par exemple un doigt, s'approche du capteur, il masque la luminosité ambiante, et provoque donc une variation de luminosité détectée par le capteur. En utilisant les propriétés de variations de la résistance électrique de la couche piézorésistive et de la couche photosensible, et en connectant celles-ci en parallèle, il est ainsi obtenu une variation élevée de la résistance électrique de l'ensemble lorsqu'un doigt presse le capteur et masque la lumière. Une telle variation peut notamment être mesurée de manière statique, par exemple par l'application d'un courant électrique constant de valeur connue dans le capteur et par la mesure de la tension résultante aux bornes de ce dernier. La variation de la tension au-delà d'un seuil prédéterminé permet alors de caractériser la pression exercée sur le capteur.

Selon un mode de réalisation, la couche piézorésistive et la couche photosensible sont séparées par un milieu plus déformable que la couche piézorésistive, notamment par un liquide fluide ou visqueux, un gaz comme de l'air par exemple, un gaz sous une pression réduite, du vide, etc..., ce qui autorise une grande déformation de la couche piézorésistive, et donc une forte variation de sa résistance électrique.

Selon un mode de réalisation, la couche piézorésistive est agencée sur une face d'une couche de protection électriquement isolante, au moins partiellement transparente à la lumière et déformable, et dans lequel l'empilement formé de la couche piézoresistive et de la couche de protection comporte des ouvertures agencées au droit de la couche photosensible. La sensibilité du capteur aux variations de luminosité ambiante est ainsi augmentée sensiblement par la présence des ouvertures.

Selon un mode de réalisation, la couche piézorésistive est réalisée sous la forme d'un serpentin présentant un nombre variable de virages par unité de surface, et notamment un nombre de virages plus important dans une zone centrale du capteur que le nombre de virages dans des zones périphériques du capteur. Tout d'abord, un serpentin présente une largeur très inférieure à sa longueur. Une déformation du serpentin induit ainsi une variation élevée de sa résistance électrique. En outre, le nombre de virages par unité de surface permet de disposer d'une sensibilité variable du capteur sur sa surface, notamment une sensibilité plus importante dans une zone centrale de celui-ci.

De manière avantageuse, le serpentin chemine entre des ouvertures formées dans la couche de protection, notamment entre des rangées d'ouvertures.

Selon un mode de réalisation, la couche piézorésistive est réalisée en PEDOT:PSS. Le PEDOT:PSS est un mélange de poly(3,4-éthylènedioxythiophène), ou « PEDOT », et de poly(styrène sulfonate). Le PEDOT : PSS est un matériau piézorésistif, dont la résistance électrique varie sensiblement en fonction des contraintes qui lui sont appliquées. Le PEDOT :PSS présente également l'avantage d'être transparent au rayonnement visible et proche infrarouge.

Selon un mode de réalisation, la couche photosensible comporte un mélange de graphène et de dioxyde d'étain dopé par de l'antimoine, ou « ATO ». Ce matériau présente le double avantage d'être sensible à un large spectre de rayonnement, notamment à la longueur d'onde du rouge du spectre visible et du spectre proche infrarouge, et de présenter une résistance électrique qui diminue en fonction de la quantité de rayonnement collectée. Notamment, un doigt, qui émet une quantité importante de rayonnement infrarouge, est détecté par la couche photosensible même si la lumière visible ambiante est très faible. En outre, les matériaux piézorésistifs présentent généralement une résistance électrique qui augmente lorsqu'ils sont soumis à une contrainte. En connectant en parallèle une résistance électrique qui augmente par la présence d'un objet et une résistance électrique qui diminue en raison cette même présence, il est obtenu une forte variation de la résistance électrique de l'ensemble, et donc un capteur de très grande sensibilité.

Notamment, la proportion en poids du dioxyde d'étain dopé dans le mélange est supérieure à 20%. On a ainsi pu noter que cette proportion permet une collecte optimale du rayonnement. Pour des pourcentages inférieurs, on observe que la sensibilité de détection diminue.

Selon un mode de réalisation, la couche photosensible est réalisée entre la couche piézorésistive et une couche réfléchissant la lumière. La couche réfléchissante permet de renvoyer vers la couche photosensible le rayonnement ayant traversé celle-ci, par exemple en raison d'une épaisseur faible de cette couche. De cette manière, la sensibilité du capteur est augmentée.

Notamment, la couche réfléchissante est apte à réfléchir des longueurs d'onde dans le domaine du visible et du proche infrarouge.

De manière avantageuse, la couche photosensible est séparée de la couche réfléchissante d'une distance $d = \dfrac{\lambda}{4n}$, où $\lambda$ est une longueur d'onde du proche infrarouge et $n$ est l'indice de réfraction du milieu séparant la couche photosensible de la couche réfléchissante. De cette manière, un phénomène de résonnance est obtenu dans la couche photosensible pour la longueur d'onde $\lambda$ choisie, ce qui augmente la sensibilité du capteur à cette longueur d'onde.

Selon un mode de réalisation, la couche piézorésistive et la couche photosensible sont reportées l'une sur l'autre à l'aide de billes métalliques les connectant électriquement en parallèle. De cette manière, il est possible de fabriquer indépendamment l'une de l'autre les couches sensibles puis de les reporter. Ensuite, les billes permettent de régler la distance séparant celles-ci, notamment pour focaliser la lumière incidente sur la couche photosensible.

Notamment, la couche piézorésistive et la couche photosensible sont reportées l'une sur l'autre à l'aide d'empilements d'au moins deux billes conductrices solidarisées l'une à l'autre par un insert. De cette manière, il est possible de régler la distance séparant la couche piézorésistive et la couche photosensible en réglant le nombre de billes empilées.

## BREVE DESCRIPTION DES FIGURES

L'invention sera mieux comprise à la lecture de la description qui suit, donnée uniquement à titre d'exemple, et réalisée en relation avec les dessins annexés, dans lesquels des références identiques désignent des éléments identiques ou analogues, et dans lesquels :

- la figure 1 est une vue schématique en coupe d'un capteur selon l'invention ;
- la figure 2 est une vue schématique de dessus du capteur de la figure 1 ;
- la figure 3 est une vue schématique de dessus d'une variante du capteur de la figure 2;

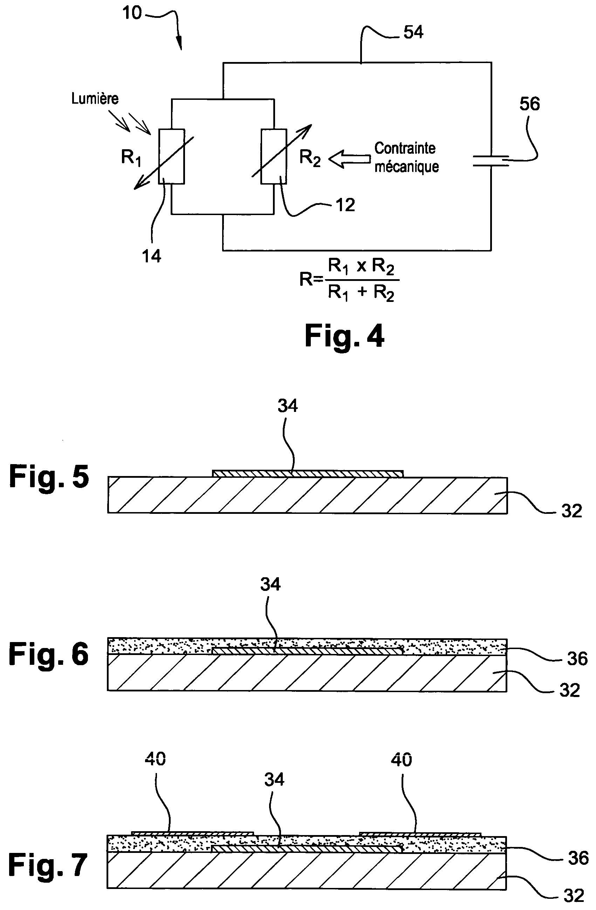

■ la figure 4 est un schéma électrique équivalent du capteur selon l'invention ;

■ les figures 5 à 16 sont des vues schématiques illustrant un procédé de fabrication d'un capteur selon l'invention ; et

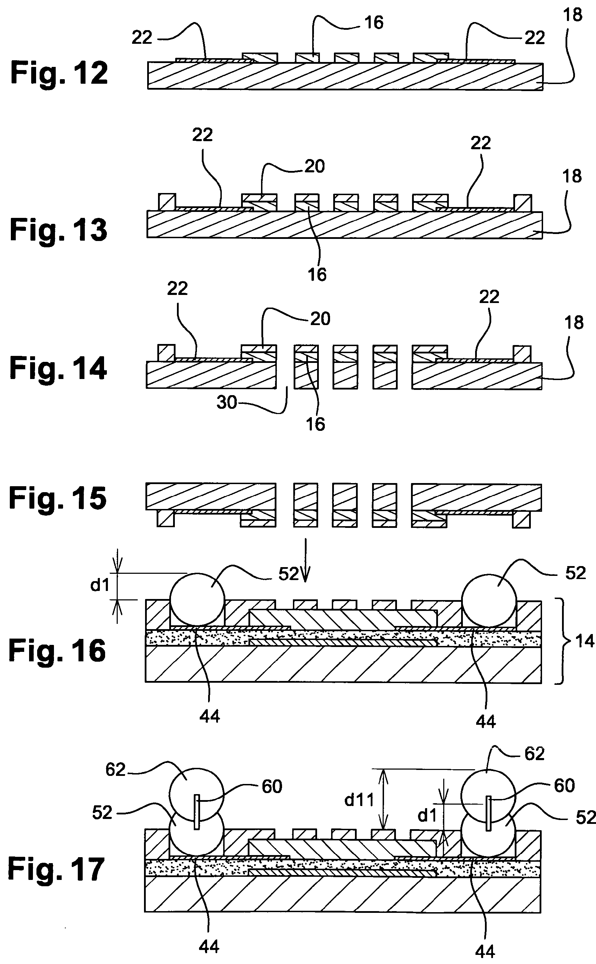

■ la figure 17 est une vue schématique en coupe d'une variante de billes pour l'hybridation de deux parties du capteur selon l'invention.

## DESCRIPTION DETAILLEE DE L'INVENTION

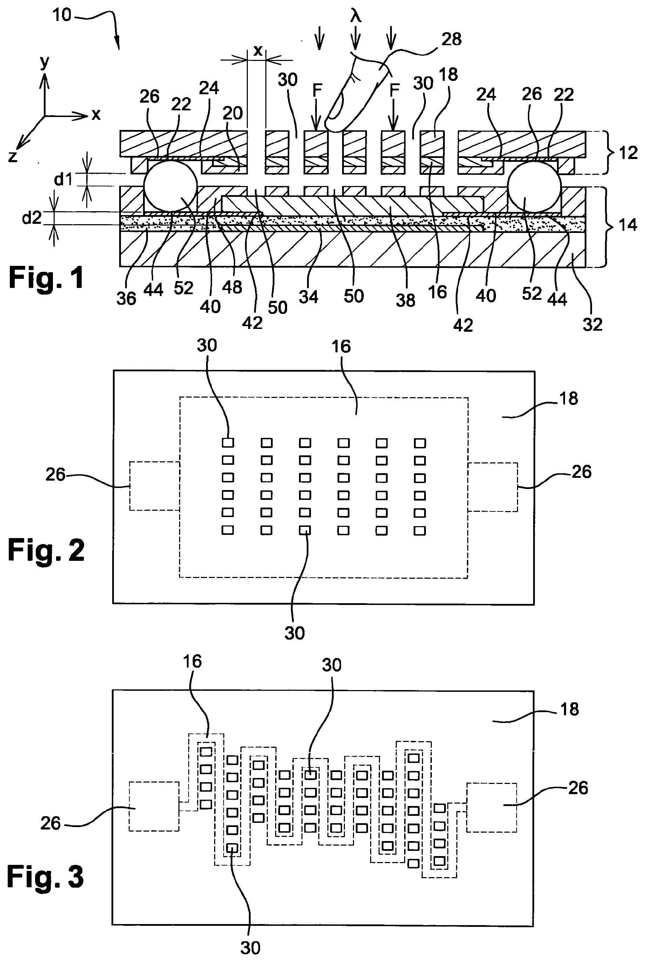

En se référant à la vue schématique en coupe de la figure 1, un capteur tactile **10** selon l'invention, par exemple destiné à être incorporé dans un écran, un clavier, ou un pavé tactile, comporte un capteur de pression **12** et un capteur de lumière **14**. Ce dernier est disposé sous le capteur de pression **12** et au droit de celui-ci, les deux capteurs **12, 14** étant connectés électriquement en parallèle.

Le capteur de pression **12** comporte une couche piézorésistive **16**, constituée d'un matériau piézoélectrique, dont la résistance électrique varie en fonction des contraintes mécaniques que ce matériau subit, intercalée entre des couches de protection, notamment un substrat flexible **18** définissant une surface tactile, et une couche de protection électriquement isolante **20**.

La couche piézorésistive **16** est avantageusement constituée de PEDOT : PSS, par exemple d'une épaisseur comprise entre 10nm et 5$\mu$m. Le PEDOT : PSS est un matériau piézorésistif, c'est-à-dire un matériau dont la résistance électrique varie fortement avec les contraintes qu'il subit comparativement à d'autres types de matériaux piézorésistifs connus. En outre, le PEDOT : PSS est également sensible à la température, et sa résistance électrique diminue avec l'augmentation de la température. De plus, ce matériau est sensiblement transparent au rayonnement visible et proche infrarouge.

Des éléments conducteurs **22,** par exemple constitués d'or, de platine, de nickel, de cuivre, d'argent ou d'aluminium, sont en outre réalisés sur le substrat **18** au contact de la couche piézorésistive **16,** afin de soumettre celle-ci à une tension et/ou d'injecter dans celle-ci un courant électrique, comme cela sera expliqué plus en détail par la suite. Par exemple, les éléments conducteurs **22** comportent deux ensembles de pistes métalliques **24** au contact de la couche **16** et raccordés respectivement à deux plages métalliques **26**.

Le substrat flexible **18** est choisi déformable sous la pression exercée par un objet à sa surface, par exemple par un doigt **28** ou un stylet. Le substrat flexible **18** est par exemple constitué d'une couche de plastique mince d'une épaisseur comprise entre 25$\mu$m et 200$\mu$m.

Le capteur de pression **12** est par ailleurs conçu transparent, au moins partiellement, au rayonnement détecté par le capteur de lumière **14**. La transparente est obtenue par le choix des matériaux constitutifs du capteur **12,** et/ou l'épaisseur des couches constitutives de celui-ci et/ou en aménageant dans le capteur des passages privilégiés pour la lumière, par exemple des ouvertures.

Avantageusement, le substrat **18** est donc constitué d'un matériau au moins partiellement transparent à la lumière visible. A cet effet, le substrat **18** est constitué de polyéthylène naphtalate (« PEN ») ou de poly(éthylène téréphtalate) (« PET »), qui présente le triple avantage d'être flexible, transparent au spectre visible et au proche infrarouge et d'être peu onéreux..

De même, la couche de protection **20** est réalisée préférentiellement dans un matériau diélectrique transparent, au moins partiellement, au rayonnement détecté par le capteur **14**. Par exemple, la couche **20** est une couche de fluoro-polymère de type CYTOP, qui est transparent et présente une faible permittivité, d'une épaisseur comprise entre 10 nanomètres et 500 nanomètres.

Des ouvertures **30** sont également réalisées au travers du capteur de pression **12,** et au droit du capteur de lumière **14,** afin d'augmenter la transparence globale du capteur **12**. Par exemple, comme cela est illustré sur la vue schématique de dessus de la figure 2, un réseau bidimensionnel, notamment périodique, d'ouvertures est réalisée au travers du substrat **18,** de la couche piézorésistive **16,** et de la couche de protection **20**. Les ouvertures sont par exemple de section carrée et de côté compris entre 50 nanomètres et 5 micromètres. La couche piézorésistive **16 est** quant à elle réalisée sous la forme d'une couche rectangulaire pleine traversée par les ouvertures **30**.

De manière avantageuse, et comme cela est illustré sur la vue schématique de dessus de la figure 3, la couche piézorésistive **20** prend en variante la forme d'un serpentin cheminant entre des rangées d'ouvertures **30**. Un serpentin présente une longueur très supérieure à sa largeur, de sorte qu'il est obtenu une variation accrue de sa résistance électrique en fonction de la pression exercée sur sa surface. De préférence, le serpentin comporte plus de virages dans une zone centrale du capteur de pression **12** qu'à la périphérie de celui-ci. De cette manière, le capteur de pression est plus sensible sur cette zone centrale qu'à sa périphérie grâce à la faible fréquence de résonnance qui donne un maximum de contrainte au centre de la structure piézorésistive.

En se référant de nouveau à la figure 1, le capteur de lumière **14** comporte un substrat **32** sur lequel repose une couche réfléchissante **34**. La couche **34** est recouverte d'une couche **36** en matériau électriquement isolant et au moins partiellement transparent au rayonnement détecté par le capteur de lumière **14**. Celui-ci comporte également une couche photosensible **38** réalisée sur la couche isolante **36**. Des éléments conducteurs **40,** par exemple constitués d'or, de platine, de nickel, de cuivre, d'argent ou d'aluminium, sont en outre réalisés sur la couche isolante **36** au contact de la couche photosensible **38** afin de soumettre celle-ci à une tension et/ou d'injecter dans celle-ci un courant électrique, comme cela sera expliqué plus en détail par la suite. Par exemple, les éléments conducteurs **40** comportent deux ensembles de pistes métalliques **42** au contact de la couche **38** et raccordés à deux plages métalliques **44.** L'ensemble est optionnellement recouvert d'une couche de protection électriquement isolante **48,** hormis les plages conductrices **44** qui restent dégagées, et des ouvertures **50** sont réalisées dans la couche **48** au droit des ouvertures **30** du capteur de pression **12.**

Le substrat **32** est avantageusement un substrat flexible et transparent, par exemple un substrat en plastique, tel que du PEN ou du PET, d'une épaisseur comprise entre 25 $\mu$m et 200$\mu$m.

La couche photosensible **38** est quant à elle avantageusement constituée d'un mélange de graphène et d'ATO (dioxyde d'étain dopé par de l'antimoine (SnO2 :Sb)), la proportion en poids d'ATO dans le mélange est avantageusement supérieure à 20%. Un tel matériau est capable de capter dans le spectre visible (notamment dans le rouge) ainsi que dans le proche infrarouge et présente en outre une résistance électrique qui diminue en fonction de la quantité de rayonnement captée. La couche photosensible **38** capte ainsi les variations de lumière ambiante induite par la présence du doigt **28,** ainsi que les variations de chaleur induites par la présence du doigt **28,** ces variations de chaleur se traduisant par des variations du rayonnement proche infrarouge émis par le doigt.

De manière optionnelle, le matériau de la couche isolante **36** ainsi que la distance séparant la couche photosensible **38** de la couche réfléchissante **34** sont choisis de manière à satisfaire la relation $d = \dfrac{\lambda}{4n}$, où *d* est ladite distance, $\lambda$ est une longueur d'onde du proche infrarouge et *n* est l'indice de réfraction de la couche **36.** Il est ainsi obtenu un phénomène de résonnance électromagnétique à la longueur d'onde $\lambda$ qui accroit la sensibilité du capteur **12** à cette longueur d'onde.

La couche réfléchissante **34** est réalisée dans un matériau présentant une réflexion importante du rayonnement détecté par la couche photosensible **38.** Par exemple la couche réfléchissante est une couche métallique en argent, en aluminium ou en or, ces matériaux présentant un fort pouvoir réflecteur dans le domaine visible et du proche infrarouge.

La couche isolante **36** est quant à elle constituée d'un matériau transparent au rayonnement détecté par la couche photosensible **38,** par exemple un diélectrique de type polymère organique ou un oxyde inorganique tel que du SiO$_2$, du ZrO$_2$, du TiO$_2$, etc. Ces matériaux présentent une forte transparence dans le domaine visible et proche infrarouge.

Le capteur de pression **12** et le capteur de lumière **14** sont avantageusement reportés l'un sur l'autre à l'aide de billes métalliques **52,** chacune disposée entre des plages de connexion **26, 44** disposée en regard respectivement sur les capteurs **12, 14.** Les capteurs **12** et **14** sont donc connectés électriquement en parallèle. En outre, les billes **52** espacent ceux-ci d'une distance d$_1$ permettant au capteur de pression **12** de se courber fortement sous la pression exercée à sa surface, et donc de subir une forte variation de sa résistance électrique. L'espace séparant le capteur de pression **12** et le capteur de lumière **14** est par exemple rempli par un gaz, comme de l'air, sous une pression réduite ou non, du vide, un liquide fluide ou visqueux, etc...Bien entendu, ces deux fonctions peuvent être mises en oeuvre par des éléments distincts.

La figure 4 est un schéma électrique équivalent du capteur selon l'invention. Les couches piézorésistive **16** et photosensible **38** étant connectées électriquement en parallèle, le capteur **10** présente une résistance électrique totale égale à $R = \dfrac{R_1 \times R_2}{R_1 + R_2}$, où $R_1$ et $R_2$ sont respectivement les résistances électriques de la couche photosensible et de la couche piézorésistive.

Le capteur **10** est par exemple connecté à un circuit électrique **54** comportant une source de courant ou de tension constante permettant de réaliser une mesure statique de sa résistance ou d'un grandeur électrique liée à celle-ci, cette mesure étant analysée par un circuit de traitement analogique ou numérique (non représenté) pour déterminer un évènement à la surface du capteur, comme la présence d'un doigt par exemple.

Le capteur **10** selon l'invention combine ainsi trois modes de détections différents, à savoir un mode de détection tactile piézorésistive, un mode de détection lumineux, ainsi qu'un mode de détection combinant le mode de détection tactile et lumineux.

Dans le mode de détection piézorésistif, la pression exercée sur le substrat **18** induit un effet piézorésistif, à savoir la variation de la résistance électrique de la couche piézorésistive **16** sous l'effet de la contrainte qu'elle subit. Le fait d'appuyer sur le substrat **18** provoque en effet une déformation locale de la couche piézorésistive **16,** ce qui engendre une variation de sa résistance électrique, variation qui se traduit par une variation correspondante d'une grandeur électrique, notamment un courant ou une tension électrique. La pression exercée est ensuite déterminée en utilisant par exemple une table de valeurs de variations prédéterminées de la grandeur électrique mesurée en fonction de valeurs de pression exercée.

Dans le mode de détection lumineuse, lorsqu'une face, ou les deux faces du capteur **10** sont éclairées, la résistance électrique de la photorésistance constituée de la couche photosensible **38** varie en fonction de l'intensité lumineuse, et la variation de cette résistance est traduite en une grandeur électrique, courant ou tension, qui est lue par un circuit de lecture d'une manière analogue à celle-décrite ci-dessus. En outre, le mode de détection lumineuse permet de détecter également des ondes thermiques dans le proche infrarouge, et permet donc la détection d'un doigt lorsque la lumière ambiante dans le spectre visible est de faible intensité. On notera également que les matériaux et les couches constitutives du capteur de lumière **14** permettent une détection d'une lumière incidente sur le substrat **32,** d'où la possibilité d'une détection uniquement lumineuse si l'application le nécessite.

Dans le mode de détection combinant la détection piézorésistive et la détection lumineuse, un objet exerçant une pression à la surface du capteur de pression **12** masque également la luminosité ambiante et provoque donc une variation lumineuse captée par le capteur de lumière **14.** Lorsque l'objet est un doigt, des ondes thermiques dans le proche infrarouge peuvent en outre être détectées par ce dernier. La combinaison de ces phénomènes engendre une forte variation de la résistance électrique globale du capteur, permettant une détection de haute sensibilité.

Il va à présent être décrit en relation avec les figures 5 à 16 un procédé de fabrication d'un capteur selon l'invention, les capteurs **12** et **14** étant fabriqués indépendamment l'un de l'autre.

La fabrication du capteur de lumière **14** débute par la réalisation d'un substrat **32** en plastique flexible bat coût de type PEN ou PET et d'une épaisseur comprise entre 25 et 200 micromètres, et se poursuit par le dépôt d'une couche métallique réfléchissante **34,** par exemple en argent, en aluminium ou en or, au moyen d'un dépôt physique en phase vapeur, d'une sérigraphie ou d'une impression jet d'encre (figure 5).

Une couche isolante électriquement et transparente **36** est ensuite déposée, par exemple au moyen d'un dépôt physique en phase vapeur, d'une sérigraphie ou d'une impression jet d'encre, sur l'ensemble obtenu. L'épaisseur de la couche **36** est choisie de manière à maximiser le reflet du flux lumineux sur l'élément photosensible, qui sera par la suite déposé (figure 6). Le matériau constitutif de la couche **36** est par exemple un diélectrique de type polymère organique ou un oxyde de passivation inorganique tel que du $SiO_2$, $ZrO_2$, $TiO_2$, ou autres.

Deux électrodes de connexion **40** sont alors réalisées sur la couche **36** au moyen d'un dépôt physique en phase vapeur, d'une sérigraphie ou d'une impression jet d'encre (figure 7). Les électrodes **40** sont par exemple constituées de graphène conducteur ou d'un métal, notamment de l'or, de l'argent, de l'aluminium, du platine, du cuivre, ou du titane.

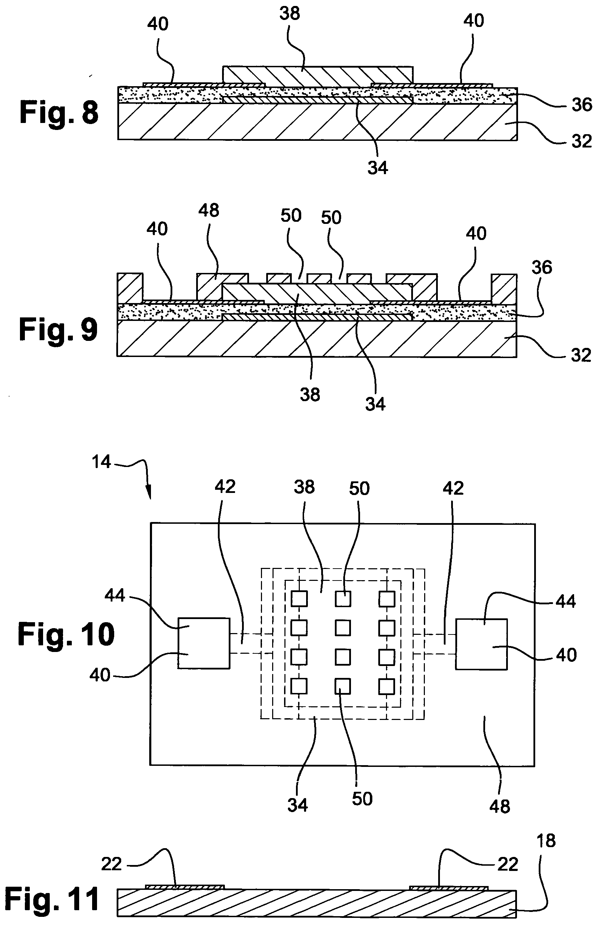

Le procédé se poursuit par le dépôt de la couche photosensible **38** constituée d'un mélange de graphène et d'ATO avec un minimum de 20% en poids d'ATO (figure 8). Le dépôt est réalisé par exemple au moyen d'une sérigraphie ou d'une impression jet d'encre déposant un mélange d'une encre de graphène conducteur et d'une encre d'ATO. Les solvants de l'encre de graphène et de l'encre d'ATO ont avantageusement une température d'évaporation proche l'une de l'autre afin de former une couche déposée très uniforme. Les températures d'évaporation des solvants sont également avantageusement choisies, compatibles en termes de recuit, avec une température de recuit des couches déjà formées lors du dépôt du mélange d'encres, et notamment des températures d'évaporation inferieures à la température de transition vitreuse du substrat en plastique **32.** Notamment, les températures d'évaporation sont comprises entre 110 et 180 °C.

Une couche de diélectrique **48** est ensuite déposée sur l'ensemble, par exemple au moyen d'un dépôt physique en phase vapeur, d'une sérigraphie ou d'une impression jet d'encre, et des ouvertures **50** sont réalisées dans la couche **48** jusqu'à la couche photorésistive **38** (figures 9 et 10). Les ouvertures sont par exemple réalisées au moyen d'une sérigraphie ou d'une lithographie.

La fabrication du capteur de pression **12** débute quant à elle par la réalisation d'un substrat **18 en** plastique flexible bat coût de type PEN ou PET, d'une épaisseur comprise entre 25 et 200 micromètres, et se poursuit par la réalisation de deux électrodes **22,** notamment au moyen d'un dépôt pleine plaque, par exemple un dépôt physique en phase vapeur ou par sérigraphie ou par impression jet d'encre, suivi d'une gravure chimique, physique ou par laser, afin de définir les électrodes **22** (figure 11). Les électrodes **22** sont par exemple constituées de graphène conducteur ou d'un métal, notamment de l'or, de l'argent, de l'aluminium, du platine, du cuivre, ou du titane.

Le procédé se poursuit par le dépôt et la définition de la géométrie du matériau piézorésistif. Une couche piézorésistive **16,** avantageusement constituée de PEDOT:PSS, est déposée sur le substrat **18** et partiellement sur les deux électrodes **22,** par exemple par sérigraphie ou par impression jet d'encre. La forme géométrique de la couche piézorésistive **16** est avantageusement choisie pour augmenter la sensibilité du capteur de pression **12** au centre de celui-ci en définissant le motif en serpentin avec des virages resserrés au centre du capteur (figure 12).

Une couche de protection transparente **20** en matériau isolant, par exemple diélectrique, est ensuite déposée sur l'empilement obtenu pour la protection de la couche de PEDOT:PSS **16** (figure 13). La couche **20** est par exemple déposée par sérigraphie ou par impression jet d'encre, et plus généralement au moyen d'un dépôt basse température compatible avec le substrat en plastique **18.** Un recuit est ensuite appliqué pour rigidifier la couche **20.**

Des ouvertures **30** sont ensuite réalisées dans le substrat **18,** par exemple au moyen d'une gravure laser, d'une gravure par plasma, ou d'une gravure chimique, au travers d'un masque de lithographie (figure 14). Les dimensions des ouvertures **30** dans l'épaisseur du substrat **18,** et donc au travers du capteur de pression **12,** sont avantageusement optimisées pour disposer d'un maximum de transfert lumineux vers le capteur de lumière **14.** Notamment, les dimensions des ouvertures sont choisies pour limiter, ou éviter les phénomènes de diffraction par les couches formant le capteur de pression **12** pour les longueurs d'onde détectées par le capteur de lumière **14.**

Une fois les capteurs de pression **12** et de lumière **14** terminés, ils sont assemblés préférentiellement à l'aide d'une encre conductrice, par exemple à base d'argent.

Notamment, une goutte d'une encre conductrice de type époxy ou autre comprenant de l'argent est déposée sur chacune des plages de connexion **44** du capteur de lumière **12,** par exemple par sérigraphie ou au moyen d'une micro seringue. Le volume d'encre et les conditions de dépôt de celles-ci permettent de régler la distance $d_1$ séparant le capteur de pression **12** du capteur de lumière **14** (figure 16). Un recuit léger est alors réalisé pour solidifier la surface des gouttes d'encre puis le capteur de pression **12** est alors reporté sur les billes conductrices **52.** Un recuit final est alors appliqué pour solidifier l'ensemble des billes conductrices.

Il est également possible de régler la distance séparant les deux capteurs **12, 14** en empilant des gouttes, dont on connaît individuellement les dimensions. Par exemple, si le dépôt d'une goutte permet de définir une distance standard connue, il est possible de doubler cette distance, en empilant deux gouttes.

En se référant à la figure 17, une première goutte d'encre conductrice **52** est déposée sur chaque plage de connexion **44,** puis un recuit superficiel des gouttes est appliqué afin de solidifier leurs surfaces supérieures.

Un insert métallique **60** rigide, conducteur, et présentant des propriétés élevées d'adhérence avec l'encre conductrice, est ensuite inséré dans chacune des gouttes pour supporter mécaniquement la structure du capteur final et pour prévenir la fatigue de celui-ci faisant suite à des multiples touchers tactiles qu'il subira.

Par exemple, les inserts **60** sont des bâtonnets de nanotubes de carbone conducteur, de tungstène, de nickel, de nitrure de titane, ou de nitrure de tungstène.

Une deuxième goutte **62** est alors déposée sur chacune des premières gouttes **52,** puis un recuit est appliqué pour rigidifier l'ensemble.

D'autres types de report sont bien entendus possible, le report au moyen d'une encre conductrice présentant l'avantage de ne pas nécessiter des températures incompatibles avec les matériaux plastiques présents dans le capteur.

Il a été décrit une couche piézorésistive transparente en PEDOT:PSS. D'autres matériaux sont cependant possibles, comme par exemple du graphène.

De même il a été décrit une couche photosensible constituée d'un mélange de graphène et d'ATO. D'autres matériaux photosensibles sont également possibles.

**Revendications**

1. Capteur tactile (10) comportant :

   ■ une couche piézorésistive (16), dont la résistance électrique varie en fonction de contraintes mécaniques exercées sur celle-ci, la couche piézorésistive (16) étant au moins partiellement transparente à la lumière ;
   ■ une couche photosensible (38), dont la résistance électrique varie en fonction de la quantité de lumière incidente sur celle-ci, la couche photosensible (38) étant agencée en regard de la couche piézorésistive (16); et
   ■ des éléments de connexion électriques (22, 40, 52) connectant électriquement en parallèle la couche piézorésistive (16) et la couche photosensible (38).

2. Capteur tactile selon la revendication 1, dans lequel la couche piézorésistive (16) et la couche photosensible (38) sont séparées l'une de l'autre par un milieu plus déformable que la couche piézorésistive (16).

3. Capteur tactile selon la revendication 1 ou 2, dans lequel la couche piézorésistive (16) est agencée sur une face d'une couche de protection électriquement isolante (20), au moins partiellement transparente à la lumière et déformable, et dans lequel l'empilement formé de la couche piézorésistive (16) et de la couche de protection (20) comporte des ouvertures (30) agencées au droit de la couche photosensible (38).

4. Capteur tactile selon l'une quelconque des revendications précédentes, dans lequel la couche piézorésistive (16) est réalisée sous la forme d'un serpentin présentant un nombre variable de virages par unité de surface, et notamment un nombre de virages plus important dans une zone centrale du capteur que le nombre de virages dans des zones périphériques du capteur.

5. Capteur tactile selon les revendications 3 et 4, dans lequel le serpentin chemine entre des ouvertures (30) formées dans la couche de protection (20), notamment entre des rangées d'ouvertures.

6. Capteur tactile selon l'une quelconque des revendications précédentes, dans lequel la couche piézorésistive (16) est réalisée en PEDOT:PSS.

7. Capteur tactile selon l'une quelconque des revendications précédentes, dans lequel la couche photosensible (38) comporte un mélange de graphène et de dioxyde d'étain dopé par de l'antimoine.

8. Capteur tactile selon la revendication 7, dans lequel la proportion en poids du dioxyde d'étain dopé dans le mélange est supérieure à 20%.

9. Capteur tactile selon l'une quelconque des revendications précédentes, dans lequel la couche photosensible (38) est réalisée entre la couche piézorésistive (16) et une couche réfléchissant la lumière (34).

10. Capteur tactile selon la revendication 9, dans lequel la couche réfléchissante (34) est apte à réfléchir des longueurs d'onde dans le visible et dans le proche infrarouge.

11. Capteur tactile selon l'une quelconque des revendications précédentes, dans lequel la couche piézorésistive (16) et la couche photosensible (38) sont reportées l'une sur l'autre à l'aide de billes conductrices (52) les connectant électriquement en parallèle.

12. Capteur tactile selon la revendication 11, dans lequel la couche piézorésistive (16) et la couche photosensible (38) sont reportées l'une sur l'autre à l'aide d'empilements d'au moins deux billes conductrices (52) solidarisées l'une à l'autre par un insert (60).

**Patentansprüche**

1. Taktiler Sensor (10), umfassend:

   • eine Piezowiderstandsschicht (16), deren elektrischer Widerstand in Abhängigkeit von auf diese ausgeübten mechanischen Beanspruchungen variiert, wobei die Piezowiderstandsschicht (16) wenigstens teilweise für Licht transparent ist;
   • eine photosensible Schicht (38), deren elektrischer Widerstand in Abhängigkeit von der darauf einfallenden Lichtmenge variiert, wobei die photosensible Schicht (38) gegenüber der Piezowiderstandsschicht (16) angeordnet ist; und
   • elektrische Anschlusselemente (22, 40, 52), die elektrisch parallel die Piezowiderstandsschicht (16) und die photosensible Schicht (38) anschließen.

2. Taktiler Sensor gemäß Anspruch 1, bei dem die Piezowiderstandsschicht (16) und die photosensible Schicht (38) durch ein verformbareres Milieu als die Piezowiderstandsschicht (16) voneinander getrennt sind.

3. Taktiler Sensor gemäß Anspruch 1 oder 2, bei dem die Piezowiderstandsschicht (16) auf einer Seite einer elektrisch isolierenden Schutzschicht (20) angeordnet ist, wenigstens teilweise gegenüber Licht transparent und verformbar ist und bei der die aus der Piezowiderstandsschicht (16) und der Schutzschicht (20) gebildete Stapelung Öffnungen (30) umfasst, die gegenüber der photosensiblen Schicht (38) angeordnet ist.

4. Taktiler Sensor gemäß einem der voranstehenden Ansprüche, bei dem die Piezowiderstandsschicht (16) in Form einer Rohrschlange realisiert ist, die eine variable Anzahl von Wendungen per Oberflächeneinheit und insbesondere eine größere Anzahl von Wendungen in einem zentralen Bereich des Sensors als die Anzahl von Wendungen in den peripherischen Bereichen des Sensors aufweist.

5. Taktiler Sensor gemäß Anspruch 3 und 4, bei dem die Rohrschlange zwischen den Öffnungen (30), die in der Schutzschicht (20) gebildet sind, insbesondere zwischen Öffnungsreihen, verläuft.

6. Taktiler Sensor gemäß einem der voranstehenden Ansprüche, bei dem die Piezowiderstandsschicht (16) aus PEDOT: PSS realisiert ist.

7. Taktiler Sensor gemäß einem der voranstehenden Ansprüche, bei dem die photosensible Schicht (38) eine mit Antimon gedopte Mischung aus Graphen und Zinndioxid umfasst.

8. Taktiler Sensor gemäß Anspruch 7, bei dem der Gewichtsanteil des gedopten Zinnoxids in der Mischung 20 % übersteigt.

9. Taktiler Sensor gemäß einem der voranstehenden Ansprüche, bei dem die photosensible Schicht (38) zwischen der Piezowiderstandsschicht (16) und einer das Licht reflektierenden Schicht (34) realisiert ist.

10. Taktiler Sensor gemäß Anspruch 9, bei dem die reflektierende Schicht (34) geeignet ist, Wellenlängen im sichtbaren und im nahen Infrarotbereich zu reflektieren.

11. Taktiler Sensor gemäß einem der voranstehenden Ansprüche, bei dem die Piezowiderstandsschicht (16) und die photosensible Schicht (38) mithilfe von elektrisch parallel anschließenden leitenden Kugeln (52) aufeinander übertragen sind.

12. Taktiler Sensor gemäß Anspruch 11, bei dem die Piezowiderstandsschicht (16) und die photosensible Schicht (38) mithilfe von Stapelungen aus wenigstens zwei durch einen Einsatz (60) fest miteinander befestigten leitenden Kugeln (52) aufeinander übertragen sind.

**Claims**

1. A tactile sensor (10) comprising:

   - a piezoresistive layer (16) having its electric resistance varying according to mechanical stress exerted thereon, the piezoresistive layer (16) being at least partially transparent to light;
   - a photosensitive layer (38), having its electric resistance varying according to the quantity of incident light thereon, the photosensitive layer (38) being arranged opposite the piezoresistive layer (16); and
   - electric connection elements (22, 40, 52) electrically connecting in parallel the piezoresistive layer (16) and the photosensitive layer (38).

2. The tactile sensor of claim 1, wherein the piezoresistive layer (16) and the photosensitive layer (38) are separated from each other by a medium more deformable than the piezoresistive layer (16).

3. The tactile sensor of claim 1 or 2, wherein the piezoresistive layer (16) is arranged on a surface of an electrically-insulating protection layer (20), at least partially transparent to light and deformable, and wherein the stack formed of the piezoresistive layer (16) and of the protection layer (20) comprises openings (30) arranged in line with the photosensitive layer (38).

4. The tactile sensor of any of the foregoing claims, wherein the piezoresistive layer (16) is made in the form of a coil having a variable number of turns per surface area unit, and particularly a larger number of turns in a central area of the sensor than the number of turns in peripheral areas of the sensor.

5. The tactile sensor of claim 3 and 4, wherein the coil runs between openings (30) formed in the protection layer (20), particularly between rows of openings.

6. The tactile sensor of any of the foregoing claims, wherein the piezoresistive layer (16) is made of PEDOT:PSS.

7. The tactile sensor of any of the foregoing claims, wherein the photosensitive layer (38) comprises a mixture of graphene and of antimony-doped tin dioxide.

8. The tactile sensor of claim 7, wherein the proportion by weight of doped tin dioxide in the mixture is greater than 20%.

9. The tactile sensor of any of the foregoing claims, wherein the photosensitive layer (38) is formed between the piezoresistive layer (16) and a light-reflecting layer (34).

10. The tactile sensor of claim 9, wherein the reflective layer (34) is capable of reflecting wavelengths in the visible and near infrared range.

11. The tactile sensor of any of the foregoing claims, wherein the piezoresistive layer (16) and the photosensitive layer (38) are installed on each other by means of conductive balls (52) electrically connecting them in parallel.

12. The tactile sensor of claim 11, wherein the piezoresistive layer (16) and the photosensitive layer (38) are installed on each other by means of stacks of at least two conductive balls (52) attached to each other by an insert (60).

**Fig. 1**

**Fig. 2**

**Fig. 3**

$$R = \frac{R_1 \times R_2}{R_1 + R_2}$$

**Fig. 4**

**Fig. 5**

**Fig. 6**

**Fig. 7**

Fig. 8

Fig. 9

Fig. 10

Fig. 11

EP 2 839 361 B1

**Fig. 12**

**Fig. 13**

**Fig. 14**

**Fig. 15**

**Fig. 16**

**Fig. 17**

13